(19) Europäisches Patentamt
European Patent Office
Office européen des brevets

(11) Publication number: **0 499 131 A1**

# (12) EUROPEAN PATENT APPLICATION

(21) Application number: **92101917.0**

(51) Int. Cl.[5]: **G11C 29/00**, G06F 11/20

(22) Date of filing: **05.02.92**

(30) Priority: **12.02.91 US 654431**

(43) Date of publication of application:
**19.08.92 Bulletin 92/34**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Sukegawa, Shunichi**
**6909 Custer Road, Apt. No. 2905**
**Dallas, Texas 75023(US)**

(74) Representative: **Schwepfinger, Karl-Heinz, Dipl.-Ing. et al**
**Prinz, Leiser, Bunke & Partner Manzingerweg 7**
**W-8000 München 60(DE)**

## (54) High efficiency row redundancy for dynamic ram.

(57) A row redundancy scheme is disclosed which allows the enablement of a redundant array (4-RED.WARDS) of memory before the disablement of a defective and usual array (0-31) of memory. Each redundant array is capable of serving numberous usual arrays in the function of replacing rows of usual memory arrays. Consequently, considerable space saving and memory operating speed are realized by the row redundancy scheme.

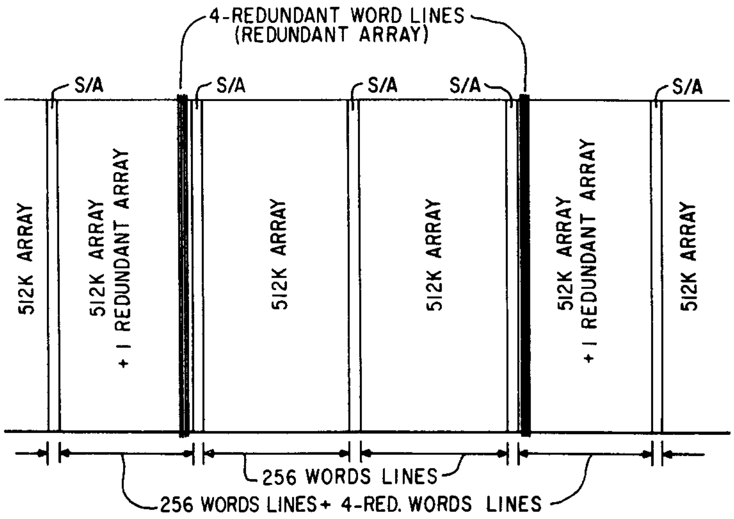


FIG. 5b

EP 0 499 131 A1

Field of the Invention

The invention is in the field of integrated circuits and more specifically, in the field of integrated circuit memory devices.

Background of the Invention

Electronic devices and systems such as printers, copiers, electronic storage devices (memories), high definition television, enhanced definition television and computational devices (e.g. calculators and computers including personal computers, minicomputers, personal work stations and microcomputers) requiring electronic storage devices, often provide data storage on a semiconductor integrated circuit chip. Because these devices often require large amounts of storage space for many applications, these storage devices are embodied in a dynamic random access memory.

As the demand has grown for increased memory space, the density of dynamic random access memories, DRAMs, has correspondingly increased. However, with increased memory density, increased memory operating speed is also demanded. Consequently, the complexity of the DRAM has likewise increased with these demands.

Defects in fabrication discovered in earlier generations of DRAMs resulted in disposal of the DRAM. This practice became too expensive and wasteful. Therefore, conventional memories often provide redundant structures (i.e. redundant word lines along with associated redundant memory cells) on the memory chip to act in place of the word line and its associated memory with which a defect is attributable. As a consequence of the redundancy, an integrated memory chip can be salvageable regardless of the defect.

Goals of increased density and speed in the development of DRAMS has resulted in the additional criterion of optimized use of chip real estate within the constraints of the desired memory density.

Prior art DRAMS have been developed for memory densities up to 16 megabits. Memories, such as the 16 megabit memory are often organized as a plurality of memory arrays with each array having a predetermined density. Such memories place a predetermined number, i.e. 4, of redundant word lines and their associated memory cells within each memory array. Generally, there are as many redundant word lines (and associated redundant memory cells) as there are memory arrays. Along with the redundant word lines and cells, row decoders for decoding word lines and the rows of redundant memory are required. Conceivably, with an increasing memory density, this redundancy scheme can result in many unused and therefore wasted redundancy word lines and associated redundancy memory cells since the number and decoding capacity of the row redundancy decoders is much smaller than the number of redundant word lines. An additional drawback of conventional redundancy schemes is that even though a large number of redundant word lines exist on a memory chip, only defects associated with a word line or a memory cell up to the number of redundant word lines in an array can be corrected in an array. For instance, if the redundancy scheme for the 16 megabit DRAM were incorporated for use in a 64 megabit memory, perhaps it could be arranged such that there are 128 arrays of approximately 512,000 (512k) rows of memory. If 4 redundant word lines exist in each array, then approximately 512 total redundant word lines (and associated circuitry) would exist on the 64 megabit chip. Thus, even though there are 512 redundant word lines on the chip, only four defective word lines are replaceable in each array. The average number of defects in conventionally sized DRAMs is 10. However, the average number of defects in a 64 megabit DRAM will probably be close to 50. Since the 16 megabit DRAM redundancy scheme requires the same number of redundant word lines as the number of memory arrays, the 16 megabit redundancy scheme incorporated into a 64 megabit memory would occupy a large amount of chip real estate.

A further drawback of conventional redundancy schemes such as a redundancy scheme for 16 megabit DRAMs is that since the defect is replaced by a redundant word line (and associated circuitry) in the same array in which the defect exists, the defective word line must be disabled before the redundant word line can be activated, otherwise a bit error may result. Consequently, this requirement slows the speed of the memory.

Until now a need has existed for a new and improved memory since conventional schemes are unacceptable, as explained above, for memory densities of 64 megabits and greater.

OBJECTS OF THE INVENTION

It is an object of the invention to provide a new and improved redundancy scheme for a memory.

It is another object of the invention to provide anew and improved row redundancy scheme for a memory.

It is a further object of the invention to provide a row redundancy scheme for a memory which dose not require the disablement of a usual array before activation of an associated redundant array.

These and other objects of the invention, together with the features and advantages thereof, will become apparent from the following detailed specification when read together with the accompanying drawings in which applicable reference numerals, letters, and symbols have been carried forward.

SUMMARY OF THE INVENTION

The foregoing objects of the invention are accomplished by a row redundancy scheme which activates a redundant array prior to disabling an associated usual array.

The scheme can be implemented in a memory architecture comprising a plurality of memory arrays in which a predetermined number of arrays each include a redundancy array. Each time a row of memory from a redundant array is chosen to replace a defective row of memory cells in a memory array, the redundant array lies outside of the array in which the defective row exists.

BRIEF DESCRIPTION OF THE DRAWINGS

Figure 1a illustrates a plan view of the architecture of the hierarchical multi-data lines memory.

Figure 1b illustrates a block diagram illustrating the flow of data to the wide data path circuit.

Figures 1c through 1e illustrate logic diagrams of possible logic accomplished in the wide data path.

Figure 2 illustrates a read/write data bus scheme which includes a schematic drawing of a wide data path circuit.

Figure 3a illustrates a plan view of another embodiment of the memory architecture.

Figure 3b illustrates a plan view of the preferred embodiment of the memory architecture.

Figure 4 illustrates one 512,00 bit memory cell array and its associated circuitry.

Figure 5a illustrates a plan view of one quadrant of the invention's memory architecture.

Figure 5b illustrates a more detailed plan view of the invention's memory architecture.

Figure 6 illustrates a logic diagram relating to the activation or disablement of a redundant array.

Figure 7 illustrates a schematic drawing of the invention's row redundancy decoder circuit.

Figure 8a illustrates a schematic drawing of a usual memory array and its associated sense amps.

Figure 8b illustrates a timing diagram for the operation of that illustrated in figure 8a.

Figure 8c illustrates a schematic drawing of a usual memory array, an associated redundant array, and associated circuitry.

Figure 8d illustrates a timing diagram for the operation of that illustrated in figure 8c.

Figure 9 illustrates a plan view of on quadrant of an alternative embodiment of the memory architecture.

Figure 10 illustrates an alternative embodiment of the invention's row redundancy decoder circuit for use in the memory architecture shown in figure 8.

ADVANTAGES OF THE INVENTION

A primary advantage of the invention is its ability to allow selection of redundant memory before disablement of the usual memory, thereby resulting in increased memory operation.

Another primary advantage of the invention lies its versatility in the replacement of a defective word line by redundant word lines.

Still another primary advantage of the invention is its compact size which results in part by its not having to provide dedicated redundant word lines for each memory array.

Detailed Description of the Invention

The invention provides a new and improved redundancy scheme suitable for high density memories, i.e. memories of the size 16 megabit, 64 megabit and greater.

The invention's redundancy scheme is most adaptable for DRAM architectures which have local input/output (I/O) lines generally running in the same direction as the memory bit lines. Such a memory architecture shall be explained below with regard to a memory size of about 64 megabits.

Figure 1a illustrates a plan view of the architecture of the hierarchical multi-data lines memory. Such a memory is ideally suited for memory sizes of 64 megabits and greater. As shown, two columns of a plurality of 512k memory arrays (for ease of illustration only one 512k array is specifically labeled) are shown with the memory arrays divided into sets of 8. Each set of eight 512k memory arrays comprise a 4 megabit block. Note that the terms 512k and 4 megabit as used herein throughout in many instances only approximate the number of memory cells. Each column of memory arrays is spaced apart from one another along a line interposed between the columns of arrays. Bond pads substantially line up along this line. A Y decoder is substantially centered in the middle of a column of memory arrays. Wide data path circuits which can operate on multiple data simultaneously are interspersed in a column between memory arrays after every eighth 512k memory array. Physically data travels on the path of local input/output lines which are shared by arrays on each side of the wide data circuit. The wide data path comprises the local input/output lines between memory arrays and the physical space therebetween. As shown in figure 1b (a block diagram illustrating the flow of data to the wide data path circuit) and figures 1c through 1e (logic diagrams illustrating possible logic accomplished in the wide data path) data travelling on said wide data path which originates from either of two memory arrays or a location external the arrays is operated upon by logic connected to the local input/output lines in the wide data path. The logic operation may comprise ANDing, ORing, SHIFTING, complements of the foregoing and combinations thereof.

An explanation of the wide data path circuit follows with reference to figure 2. Figure 2 illustrates a read/write data bus scheme which includes a schematic drawing of a wide data path circuit. A wide data path circuit is a circuit for implementing a read/write data bus scheme for a high speed DRAM such as a 64 megabit DRAM. Main input/output (I/O) lines are interposed between cell arrays. Each cell array 20 (note that only one cell array is shown in detail) contains a plurality of sense amps S/A. Selection of a sense amplifier S/A is governed by a signal from a sense amp select line S/A SEL. Line S/A SEL selects a particular sense amp S/A by delivering a high signal to the gate of a n-channel transistor 122 (Note that for illustrative purposes, only two transistors 122 are shown for one sense amplifier even though others are present). A logic high signal on section select line SEC SEL turns on transistor 21 to allow the delivery of information to and from sense amps through local differential amplifier 124 comprised on n-channel transistors 28 and 30 arranged in the symmetrical fashion shown and connected to p-channel load transistors 34. READ operations are accomplished by sending a signal form column decoder YDEC along line YREAD. Local I/O line and (a line carrying its complement) line local I/O__ are precharged high by circuitry not shown. A high S/A signal allows passage of data form a memory cell (not specifically shown) through a selected sense amp and onto a sub I/O line pair, one line carrying a true signal and the other carrying its complement signal. A differential signal from the sub I/O pair output on the gates of each transistor 28 of local differential amplifier 124 in connection with n-channel transistor 19 turning on as a result of a logic high voltage level on line YREAD creates a differential signal on a pair of local I/O lines, line I/O carrying a true signal and line I/O__ carrying its complement. Differential signals on the local I/O lines are transferred to a pair of main I/O lines through transistors 32. In connection with a WRITE operation on a memory cell, column decoder YDEC places a high signal on the gates of transistors 30 after energizing line YWRITE. Data is transferred in through n-channel transistors 46 through a pair of main I/O lines onto local lines I/O and I/O__. A drain/source connection of transistors 230 to a local line (I/O or I/O__) allows differential amplifier 124 to place data on a selected memory cell (not shown) through transistors 122 after selection by S/A SEL from a chosen sense amplifier.

With reference back to figure 1a, row decoders generally indicated at 40, lie alongside the columns of memory arrays and lie on an inner edge next to bond pads which provide bonds to the outside environment for functions such as address, control, and input/output. A row decoder is provided for each tow 4 megabit blocks of memory as shown. In connection with a signal from a Y decoder, information from/to a sense amplifier (not shown) goes from/to the wide data path circuits which connect to main input/output lines of the memory chip. A channel for placement of the main input/output lines is shown along an edge of the row decoders. The provision of a plurality of wide data path circuits to the extent of 8 per set of 512K memory arrays allows parallel processing and thus increased speed.

Figure 3a illustrates a plan view of another embodiment of the memory architecture. This embodiment is similar to the embodiment shown in figure 1a except that the wide data path circuits, now shown associated with four 4 megabit memory blocks, are located at each end of the columns of memory. A signal traveling from a Y decoder for sense amp selection allows selection of a sense amp and the import or export of data without back travel across the chip.

Figure 3b illustrates a plan view of the preferred embodiment of the memory architecture. In this embodiment note that two wide data path circuits are centered substantially between a Y decoder and an edge of the memory chip. Signals coming from the Y decoder travelling to the farthest most sense amp only require the sense amp to send or receive a signal half the distance as compared with the previous memory architecture embodiment since the wide data path circuit is at mid point between the Y decoder and the farthest most sense amp. Consequently, signals travelling between the Y decoder and the wide data path circuit provide service faster in the architecture shown in figure 3b than that of the embodiment shown in figure 3a. Further, the memory architecture of figure 3b is less complex than that shown in figure 1a since half as many wide data path circuits are needed in the architecture of figure 3b as compared with the architecture of figure 1a.

Figure 4a illustrates one 512,00 bit memory cell array and its associated circuitry being generally referenced at 2. One section of the array, being generally referenced at 4, is shown enlarged to facilitate discussion. The 512k array is associated with a pair of 1024 sense amplifiers grouped in sets of 4 sense amplifiers each or rather 256-pair sets of 4 sense amplifiers. One set of a pair of sense amplifiers is included within enlarged section 4 with each sense amplifier (also called sense amp) being labeled S/A. The remaining pairs of 1020 sense amplifiers are generally labeled 1k S/A. Each vertical row (indicated along the directions of arrows v) of sense amplifiers can service two 512k arrays of memory. Bit lines, generally indicated at 6, are of te twisted type and connect to two sense amplifiers form each 512k array. Therefore, each sense amplifier is connected to 4 bit lines. However, note that since only one 512k array is shown, a pair of bit line connections for each sense amplifier is truncated along an outer edge for the other 512k arrays. For operation upon a memory cell, Y decoder 8, the column decoder, selects the column of memory cells and row decoder 10 selects the row of memory cells. The transmission media from row decoder 10 are word lines. As shown, one extended arrow labeled word line and representing the same indicates word lines selection by row decoder 10. An extended arrow labeled Y select represents a column and indicates column selection by Y decoder 8. Note that the vicinity of the intersection of a word line and a column can be equated to the location of a memory cell in the 512k array. Thus, extended arrow Y SELECT could have been shown at other locations along Y decoder 8 and likewise extended arrow WORD LINE could have been shown at other locations along row decoder 10. In conjunction with row decoder 10 of the 512k array shown and Y decoder 8, sense amplifier selection is accomplished such that access to the sense amplifier is determined by sense amp selection circuitry 12 which selects the proper sense amp pair corresponding to the selected column. Sense amp selection circuitry 12 comprises transistor pairs 14, one of the transistors form pair 14 acting as a pass transistor to carry a true signal and the other transistor from the pair serving as a pass transistor to carry the complement of the true signal. Note, however, that a single transistor 14 symbol represents a pair of transistors, shown here as n-type, although p-type and bipolar transistors of the n-p-n or p-n-p variety could be used. Transistor pairs 14 are connected to an associated sub input/output line of a sub input/output pair 16. The transistor for passing the true signal is therefore connected to a sub input/output line for transmission of the true signal and the transistor for passing the complement of the true signal is connected to the other sub input/output line from the pair which serves to transmit the complement of the true signal. Note that a pair of the sense amp circuitry 12 can service an entire 512k array. A pair of pass transistors 18 are associated with each of the 256 sets of 4 sense amplifier pairs. As with transistor pair 14, transistor symbol 18 represents a pair of transistors, shown here as n-type transistors. Note, however, that p-type or bipolar transistors of the n-p-n or p-n-p variety could have been used. In connection with the selection of a particular sense amplifier S/A, determination thereof dictated in part by sense amplifier selection circuitry 12 and row decoder 10, a selected transistor pair 14 turns on. Pass transistor pair 18, associated with one of the 256 sets of sense amplifiers turns on so as to provide access to a local input/output pair 20 of lines. Like the sub input/output pair 16 and transistor pair 14 relationship, a pass transistor from pair 18 for passing a true signal connects to a local input/output line from pair 20, for transmission of a true signal. Similarly, a pass transistor from pair 18 for passing a complemented signal connects to the other local input/output line from local input/output pair 20. A local input/output pair 20 for each set of the 256 sets of sense amplifier pairs is coupled to wide data path circuitry 22. Selection determined by decoder 8 places data from selected pairs of the 256 local input/output pairs onto pairs of main input/output lines 24, the pairs comprising the true and complemented signals of the selected signals. For the particular case shown in figure 3a, 8 pairs of local input/output pair 20 are chosen from the 256 pairs of local input/output lines for placement of data onto or from the main input/output pair 24. However, fewer or more main input/output lines and consequently fewer or more local input/output pairs could have been chosen for selection and operation thereupon. 128 of the 512k memory arrays described above are used to create the 64 megabit memory. Y decoder 8 turns on selected transistors 18 for coupling data from a sub input/output line to a local input/output line. Selected transistors are located along arrow z. Sense amplifier select circuitry 12 determines which group of sense amplifiers and consequently, data from which 512k array gets placed on a sub input/output pair. For instance, if 127 512k arrays and their associated circuitry were located along arrow z, then a signal form Y decoder 8 would turn on transistors 18 for the same set of sense amplifiers in each 512k array. The same signal determines the column of a selected memory cell. Sense amplifier selection circuitry 12 exists for each 512k array in the z direction as does a row decoder 10 for each 512k array. Therefore, sense amplifier select circuitry determines which set of sense amplifiers are coupled to a sub input/output pair of lines. Note that the sense amplifier selection circuitry would couple the same sense amplifiers to sub input/output pairs in each of the 256 sets of sense amplifiers that exist along arrows v. However, Y decoder 8 determines which set out of the 256 sets gets selected so that through a transistor 18 a sub input/output pair is coupled to a local input/output pair. (The same local input/output pair is used for each array positioned along the z direction, there being 256 local input/output pairs per 512k array.) Y decoder 8 also controls multiplex selection of wide data path circuitry 22 for placement of data from the local input/output pairs to the main input/output pairs and vice versa.

Figure 4b illustrates a schematic drawing of the sense amp circuitry for the invention. More specifically, figure 4b illustrates one sense amp in a sense amp bank (column of sense amps). P-channel transistor 308 and n-channel transistor 310 form an inverter cross-coupled (input connected to output and vice versa) to another inverter formed by p-channel transistor 310 and n-channel transistor 314. Transistors PG act as pass gates or n-channel pass transistors for connection of the bit lines to the sense amp comprising transistors 308, 310, 312, and 314. Lines TG provide electrical connection to the gates of transistors PG. Equalization circuitry for the sense amplifier is provided by n-channel transistors 316, 318, and 320. When equalization signal EQ is received by the gates of these transistors, the voltage on bit lines BIT and BIT__ is equalized at around voltage Vdd/2. Note that the Vdd/2 voltage is provided at a node between transistors 316 and 318. Activation of the sense amp occurs in connection with opposite voltage states appearing on lines PC and NC. Line PC switches between low state voltage of Vdd/2 and high state voltage Vdd while line NC switches between high state voltage of Vdd/2 and low state voltage Yss (as indicated by the drawings).

Figure 5a illustrates a plan view of one quadrant (for instance the upper left quadrant) of the invention's memory architecture. The 32 512k memory arrays are illustrated as blocks numbered from 0 to 31 with a wide data path circuit positioned between array block 15 and 16 and a Y decoder (for decoding the columns of memory cells) situated near the array block numbered 31, consistent with the architecture shown in figure 3b. An array of four redundant word lines (4-RED. WORDS) are placed in array block 6 and an array of four redundant word lines are placed in array block 9. As shown, these redundant word lines are decoded by a row redundancy decoder (ROW RED. DECODER). A similar arrangement exists in blocks 22 and 25: namely, a set of 4 redundant word lines each exists in blocks 22 and 25 that are decoded by a row redundancy decoder. Note that the row redundancy decoder is contemplated as also being usuable with a greater number of sets of redundant word lines, i.e. 3, 4, 5, 6, 7, 8, 9, 10, and etc. Also, the sets of redundant word lines are contemplated as each being made of a larger or smaller number than 4 redundant word lines.

A more detailed plan view of the invention's memory architecture is illustrated in figure 5b. As shown, in each 512k array there are approximately 256 word lines. Additionally illustrated are two arrays each containing a redundancy array of 4 word lines. Note, that the foregoing is only one example embodying a concept of the invention. Consequently fewer or more word lines could form a redundant array.

Figure 6 illustrates a logic diagram relating to the activation (enablement) or disablement of a redundant array. OR gate 210 receives address bits L0 to L3. OR gate 212 receives address bits R0 to R3. The output of OR gate 210 is received by the input of inverter 214 and the output of OR gate 212 is received by the input of inverter 216. The output of inverter 214 is received by the inputs of a pair of AND gates 218. One AND gate 218 from the pair of AND gates receives as an input, bit A12, while the other AND gate 218 from the pair receives the complement of the signal at bit A12, the signal at bit A__12. The output of inverter 216 is received by the inputs of a pair of AND gates 219. One AND gate 219 receives as an input, the signal at bit A12, while the other AND gate 219 from the pair receives the signal at bit A__12. One AND gate 220 receives as input, output RARUI of AND gate 218 and output LUI of AND gate 219. Another AND gate 220 receives as input, output RAROI of AND gate 218 and output LOI of AND gate 219. When either RARUI or mutually exclusively LUI are logic high a redundant array of memory cells is activated. When output RRNUI or RRNOI of one of the AND gates 220 is high, a redundant array is disabled.

Figure 7 illustrates a schematic drawing of the invention's row redundancy decoder circuit, of which two exist in the drawing of figure 5a. The decoder comprises a series of sub-circuits each comprising an associated transistor array 224. Each field effect transistor in transistor array 224 is connected to a fuse (although a fuse symbol is used, for ease of illustration, all fuses are not labeled). All the fuses connect to the input of an associated inverter 230. The input to inverter 230 can be precharged high by precharge field effect transistor 226 (which receives an enabling precharge signal P/C) in connection with a logic high signal received at the gate of transistor 226. As shown, field effect transistor 228 has its source connected to the input of inverter 230 and its gate connected to the output of inverter 230. The output of inverter 230 is also connected to the input of inverter 232. Voltage Vcc represents the circuit supply voltage. The transistors in array 224 comprise pairs of transistors which receive at their gates an address signal and its complement. For instance, one transistor in a pair is shown receiving address input AO while the other transistor in the same pair is receiving address input A_0. Each sub-circuit outputs an associated address L0 to L3 and R0 to R3, the inputs to OR gates 210 and 212 discussed with respect to figure 6. Addresses L0 to L3 and R0 to R3 are input into array 250 and array 252. Arrays 250 and 252 each comprises a series of AND gates with the outputs of the AND gates connected to the input of an associated inverter. Consequently, in physical realization of the circuit, NAND gates are substituted for the schematic representation of an AND gate connected to the input of an inverter. Note that each AND gate in array 250 receives bit A_12 and a unique address L0 to L3 or R0 to R3. Each AND gate in array 252 receives bit A12 and a unique address bit L0 to L3 or R0 to R3. Each AND gate-inverter combination previously discussed with respect to arrays 250 and 252 has an output from which a signal is generated that is capable of enabling a redundant row of memory locations. These outputs are bits labeled from LW0 to LW7 in array 250 and from RW0 to RW7 in array 252. Applying figure 7 to the row redundancy decoder for redundant arrays in arrays 7 and 8, bits LW0 through LW7 are capable of enabling the redundant array in array 7 while bits RW0 through RW7 are capable of enabling the redundant array in array 8. Applying figure 7 to the row redundancy decoder for redundant arrays in arrays 23 and 24, bits LW0 through LW7 are capable of enabling the redundant array in array 23 while bits RW0 through RW7 are capable of enabling the redundant array in array 24. Should there exist a defect associated with a word line, this defect is noted by purposely blowing the fuses in a sub-circuit in figure 7 which correspond to a logic one true (non-complementing, i.e. excluding A_0, A_1, A_2, and etc.) bit address. Bits A_0 through A11 of the sub-circuits shown in figure 7 correspond to memory location addresses. Bits A_12 and A12, in large part, determine which redundant array is selected by the decoder. For instance, bit A_12 must be logic high before a redundant word line can be selected by outputs LW0 through LW7, and bit A12 must be logic high before a redundant word line can be selected by outputs RW0 through RW7. Consequently, redundant word line selection is determined by selection of fuses that are to be blown and selection of bits A_12 and thus A12 logic level. In connection with the fuse blowing scheme discussed above with respect to figure 7, when a known defective memory location is addressed, the appropriate fuses shall have already been blown in a particular sub-circuit, resulting in a logic high input to an inverter 230. With reference still to figure 7, inverter 232 of the same sub-circuit will consequently output a logic high signal to the input of a AND gate from either array 250 or 252. If a logic low signal serves as the other input to this same AND gate (either from a delayed signal from bit A_12 or A12 as shown), a logic high output will result at one of the AND gate-inverter combinations, LW0 to LW7 in array 250 or RW0 to RW7 in array 252. For instance, if there exists a defective word line in the array numbered 4 as illustrated in figure 5a, one of the sub-circuits shown in figure 7 will output a logic high at the output of inverter 232, or rather at one of address bits L0 to L3 or R0 to R3. Suppose a logic high is output at address bit R0 and that the signal at bit A_12 is at a logic high level. A logic high signal will result at LW4 which activates an associated redundant word line. With reference to the logic diagram of figure 6, a logic high signal at R0 and in connection with logic low signals at bits R1 through R3 and the logic high signal at bit A_12, produces a logic high output at AND gate 219's output LUI. As indicated in figure 6, when an output from AND gate 218 or 219, or rather when one of AND gate outputs RARUI, RAROI, LUI, or LOI is at a logic high voltage level, an array of redundant word lines is activated. The usual or rather non-redundant memory array associated with the defective memory location address remains is disabled after one gate delay (AND gate delay). The combination of logic low signals at L0 to L3 and the logic high signal at address bit A_12 results in a logic high level at output RRARUI at roughly the same time as the high signal at output LUI. The logic high usual array disable signal which can occur at outputs RRNUI and RRNOI, in this example RRNUI, does not occur until after the one gate delay generated by AND gate 220. The usual arrays are disabled only when an associated output, RRNUI or RRNOI is at a logic high level. However, a primary advantage of the invention occurs through increased speed of operation gained by not having to disable the usual array before disabling the redundant array.

Should a defective word line exist in the array numbered 7 in figure 5a, this word line can be replaced by one of the redundant word lines in the redundant array located within the array block numbered 8. Replacement of a defective word line is accomplished using a redundant array outside of the array in which the defective word line exists. For instance replacement of a defective word line in array 7 must be accomplished by using a redundant array other than in array 7 such as the redundant array in array 8 since the replacement scheme does not wait to disable a usual array before activating a redundant array. If the redundant array in array 7 were used to replace a defect word line in array 7 there is a possibility that selection of the defective word line could occur, thereby resulting in possible error. Similarly, a defective word line in array 8 can be replaced by a redundant word line in array 7. Likewise, with reference still to figure 5a, a defective word line in array 23 can be replaced by a redundant word line in array 24, and a defective word line in array 24 can be replaced by a redundant word line in array 23 to avoid the possible error condition discussed concerning activation of a redundant array before disablement of the usual array. Note that defective word lines in arrays 0 through 6 are usually replaced using a redundant array in array 7 and that defective word lines in arrays 9 through 15 are usually replaced using a redundant array in array 8. Further, note that defective word lines in arrays 16 through 22 are usually replaced using a redundant array in array 23 while defective word lines in arrays 25 through 31 are usually replaced using a redundant array in array 24. However, in the preferred embodiment of the invention, defects in arrays 0 through 6 and arrays 9 through 15 can be replaced by either redundant array in arrays 7 or 8, and defects in arrays 16 through 22 and 25 through 31 can be replaced by either redundant array in arrays 23 or 24. Still alternatively, defects in arrays 0 through 6, 9 through 15, 16 through 22, and 25 through 31 can be replaced by redundant arrays in either arrays 7, 8, 23, or 24. Additionally, in all of the embodiments of the invention, it is contemplated that defects within redundant arrays are replaceable with other redundant arrays.

The timing involved in the operation of the usual array shall be discussed with reference to figure 8a, a schematic drawing of a usual memory array and associated sense amps, and the timing diagram therefor in figure 8b. Initially, all TG lines are at a logic high state except for those lines serving an adjacent selected memory array. (Note that substantially each sense amp (except for those sense amps located in the beginning column or in the end column of sense amps) is capable of serving a memory array located adjacent each side of the sense amp. Therefore, once an array has been selected, sense amps for that array should not be electrically connected to the bit lines of an adjacent array.) Consequently, in figure 8a, which illustrates a left end of the memory, line TG1L must be deactivated or rather brought to a logic low state in connection with selecting the array between lines TG1R and TG0. As indicated by the timing diagram of figure 8b, the sense amps shown, which originally were at an equalized state as established by logic high equalization signals EQ1 and EQ0, start receiving logic low equalization signals indicating the removal of equalization from the bit lines of associated sense amps. Substantially at the same time, line TG1L is deactivated in accordance with the remarks above. A selected word line in the usual array is activated along with a mock word line (shown here specifically as Mock Word Line 0) which is input to inverter 340. Signal MOCKR is output from inverter 340. Signal MOCKR is used to control the activation of signals PC and NC, or rather more specifically in this instance, signals PC0, PC1, NC0, and NC1. Once signals PC0 and PC1 reach a logic high level, and signals NC0 and NC1 reach a logic low level, their associated columns of sense amps are enabled and the state of a selected cell can now be written to or read from.

The timing involved in the operation of the redundant array shall be discussed with reference to figure 8c, which illustrates schematic drawings of usual array 0 and redundant array 7, together with figure 8d which illustrates timing diagrams therefor. Should a word line in array 0 require replacement by a word line in array 7, the operation is as follows. Bit A__12's change from a logic low to a logic high state causes RARUI to change to a logic high state. RARUI causes equalization to the bit lines of sense amps on either side of array 7 to be removed by causing signals EQ8 and EQ7 (not shown) to be brought to a logic low state. RARUI additionally causes TG7R (not shown) and TG8L, which control the pass transistors for arrays adjacent array 7, to be brought to a logic low state. Thus, the sense amps for array 7 are prevented from receiving or transmitting information to the other arrays they service. After the time delay noted with respect to array 250 in figure 7, the selected redundant word line, in this instance LW0, in response to the transition of bit A__12, makes a gradual transition to a logic high state. Mock Word Line 7 makes the transition along with redundant word line LW0. The output of inverter 340 for mock word line 7 transmits a logic low MOCKR7 signal in response to mock word line 7 going low. Sense amps in the seventh and eighth columns of sense amps are enabled in connection with the transition of the MOCKR7 signal to a low logic level lines after lines PC7 and PC8 change to a logic high level and lines NC7 and NC8 change to a logic low level. RARUI causes output RRNUI to change to a logic high level. In accordance with the operation of a selected usual array, the pass transistors adjacent the array are disabled and equalization to the bit lines is removed. This is exhibited by the initial transition of EQ0 EQ1 and TG1L to logic low states. The change in RRNUI to a logic high level, which results in disabling the usual array, is responsible for the transition of EQ0, EQ1, and TG1L back to logic high levels. RRNUI also is responsible for preventing the word line corresponding to the selected address in the usual array, and its associated mock word line from fully firing (turning on). Note the characteristic triangular pulse created as a result of line impedance. The MOCKR0 signal produced as a result of the voltage on MOCK WORD LINE 0 does not significantly change. Lines PC0, PC1, NC0, and NC1 remain at their voltage levels of Vdd/2 thereby maintaining a disconnection of sense amps in the 0th and 1st columns of sense amps from their associated bit lines. Thus, array 0 and its associated circuitry are placed in a state typical of an array which has not been selected.

Figure 9 illustrates a plan view of one quadrant (for instance the upper left quadrant) of an alternative embodiment of the memory architecture. As shown, only one row redundancy decoder is needed, in contrast with that illustrated in figure 5a, to decode the rows of redundant memory. Defective word lines in arrays numbered from 0 to 12 and 14 are replaced using a redundancy array located in either array 13 or array 15. Defective word lines in array 13 are replaced using a redundancy array located in array 15 while defective word lines in array 15 are replaced using a redundancy array located in array 13 for the same reasons concerning error as addressed with respect to figure 5a. Redundancy with respect to arrays 16 through 31 mirror the same concept: namely, defective word lines in arrays numbered from 17 and 19 through 31 are replaced using a redundancy array located in either array 16 or array 18; defective word lines in array 16 are replaced using a redundancy array located in array 18; and defective word lines in array 16 are replaced using a redundancy array located in array 18.

Figure 10 illustrates an alternative embodiment of the invention's row redundancy decoder circuit for use in the memory architecture shown in figure 8. This decoder is similar to structure and operation of the decoder shown in figure 7. However, bits LW0 through LW7 activate redundant word lines in a redundant word line array in array 14 while bits RW0 through RW7 activate redundant word lines in a redundant word line array in array 16. Further, bits LU0 through LU7 activate redundant word lines in a redundant word line array in array 15 while bits RU1 through RU7 activate redundant word lines in a redundant word line array in array 17. In each sub-circuit, the output of inverter 232 is connected to the inputs of AND gates 260 and 264 which are connected to the inputs of inverters 262 and 266 respectively. These AND gate-inverter elements are physically NAND gates in their preferred embodiment. AND gates 260 and 264 are also connected to field effect transistors 268, 270, and 272. Transistor 274 is connected to transistors 268 and 270 and serves to activate the circuit (in order to produce a logic high signal at the output of inverter 266 or inverter 266) comprising fuse "A," and transistors 268, 270 and 272, in connection with receiving a signal, PULSE, at its gate. In connection with a logic high signal at bit A_12, redundant array selection in arrays 14 or 16 will occur depending upon whether fuse A is blown or intact. Should fuse "A" be blown, redundant row selection occurs in array 16. Otherwise, if fuse "A" is intact, redundant row selection occurs in array 14. In connection with a logic high signal at bit A12, redundant array selection in arrays 15 or 17 will occur depending upon whether fuse A is blown or intact. Should fuse "A" be blown, redundant row selection occurs in array 15. Otherwise, if fuse "A" is intact, redundant row selection occurs in array 17. Note that however, consistent with the embodiment discussed previously, replacement of a defective word line does not occur within the same array. Thus defective word lines in arrays 14, 15, 16, or 17 must be replaced using redundant word lines from arrays other than the array in which the defect exists. For instance, defective word lines in array 14 can be replaced using the redundancy array in array 15 and defective word lines in array 15 can be replaced using the redundancy array in array 14. Likewise, defective word lines in array 16 can be replaced using the redundancy array in array 17 and defective word lines in array 17 can be replaced using the redundancy array in array 16. Defective word lines in arrays 0 to 13 are usually replaced with word lines from a redundant array in array 14 or array 15, while defective word lines in arrays 18 to 31 are usually replaced with word lines from a redundant array in array 16 or array 17. However, in the preferred embodiment of the invention, defective word lines in arrays 0 to 13 or arrays 18 to 31 are replaced using a redundant array from arrays 14, 15, 16, or 17. Although the invention has been described in detail herein with reference to its preferred embodiment and certain described alternatives, it is to be understood that this description is by way of example only, and is not to be construed in a limiting sense. It is to be further understood that numerous changes in the details of the embodiments of the invention, and additional embodiments of the invention, will now be apparent to, and may be made by a person of ordinary skill in the art having reference to this description. It is contemplated that all such changes and additional embodiments are within the spirit and true scope of the invention as claimed below. Accordingly, the invention is intended to be limited only by the scope of the appended claims.

## Claims

**1.** A row redundancy scheme comprising:
a plurality of usual memory arrays; and
a plurality of redundant memory arrays, said redundant memory arrays being operable to function in place of any memory array selected from said usual memory arrays.

**2.** A row redundancy scheme as recited in claim 1 wherein said redundant memory arrays are further operable to function in place of memory arrays selected from said redundant memory arrays.

**3.** A row redundancy scheme as claimed in claim 1 or claim 2 and wherein said usual memory arrays are laid out adjacent to one another; and said redundant memory arrays are interposed substantially midway among said usual memory arrays.

**4.** A row redundancy scheme as claimed in any preceding claim and wherein each usual memory array comprises at leat 512,000 memory cells operable with about 256 word lines; and including
a plurality of banks of sense amplifiers, each bank being located on either side of an associated usual memory array;
said plurality of redundant memory arrays being located within selected ones of said usual memory arrays.

**5.** A row redundancy scheme as recited in claim 4, wherein each of said redundant memory arrays comprise at least 4 redundant word lines.

**6.** A row redundancy scheme as claimed in any preceding claim comprising:
a first plurality of usual memory arrays separated by and operable in connection with a wide data path circuit;
a row redundancy decoder operable for decoding a selected number of said redundant memory arrays;
said redundant memory arrays being located within selected usual arrays within said first and second plurality of usual memory arrays.

**7.** A row redundancy scheme as recited in claim 6 wherein said selected number is selected from the group of numbers consisting of 2, 4, 6, or 8.

**8.** An electronic device implementing the row redundancy scheme as claimed in any preceding claim.

**9.** An electronic device as claimed in claim 9 and wherein said electronic device is selected from the group consisting of:
a printer, a copier, a memory, a calculator, a computer, and a personal work station.

**10.** A method of implementing replacement of rows of memory in a usual array with row of memory in a redundant array comprising enabling said redundant array;
disabling said usual array; and
enabling sense amplifiers associated with said redundant array.

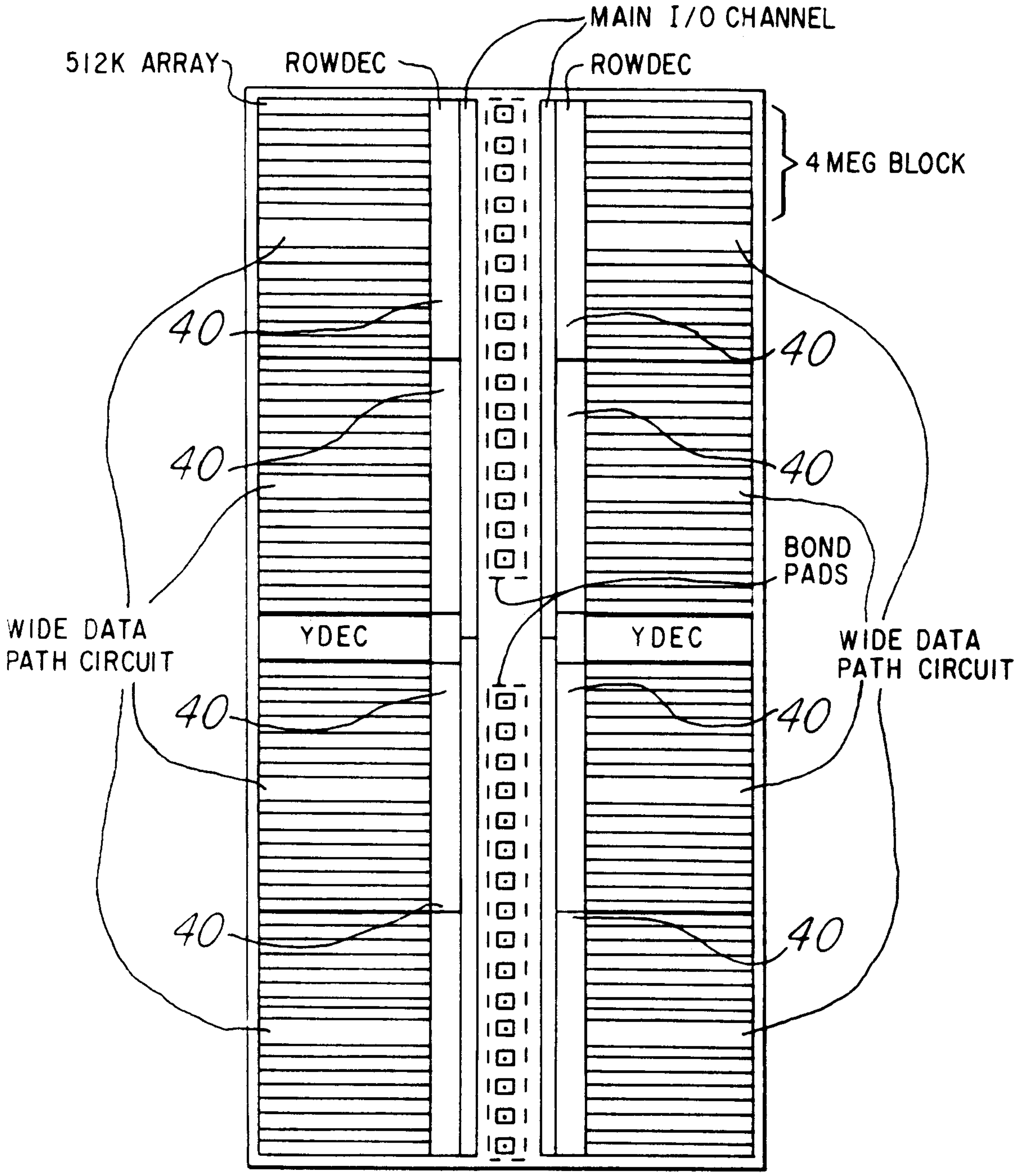
MAIN I/O CHANNEL
512K ARRAY
ROWDEC
ROWDEC
4 MEG BLOCK
40
40
40
40
40
40
40
40
BOND PADS
YDEC
YDEC
WIDE DATA PATH CIRCUIT
WIDE DATA PATH CIRCUIT

FIG. 1a

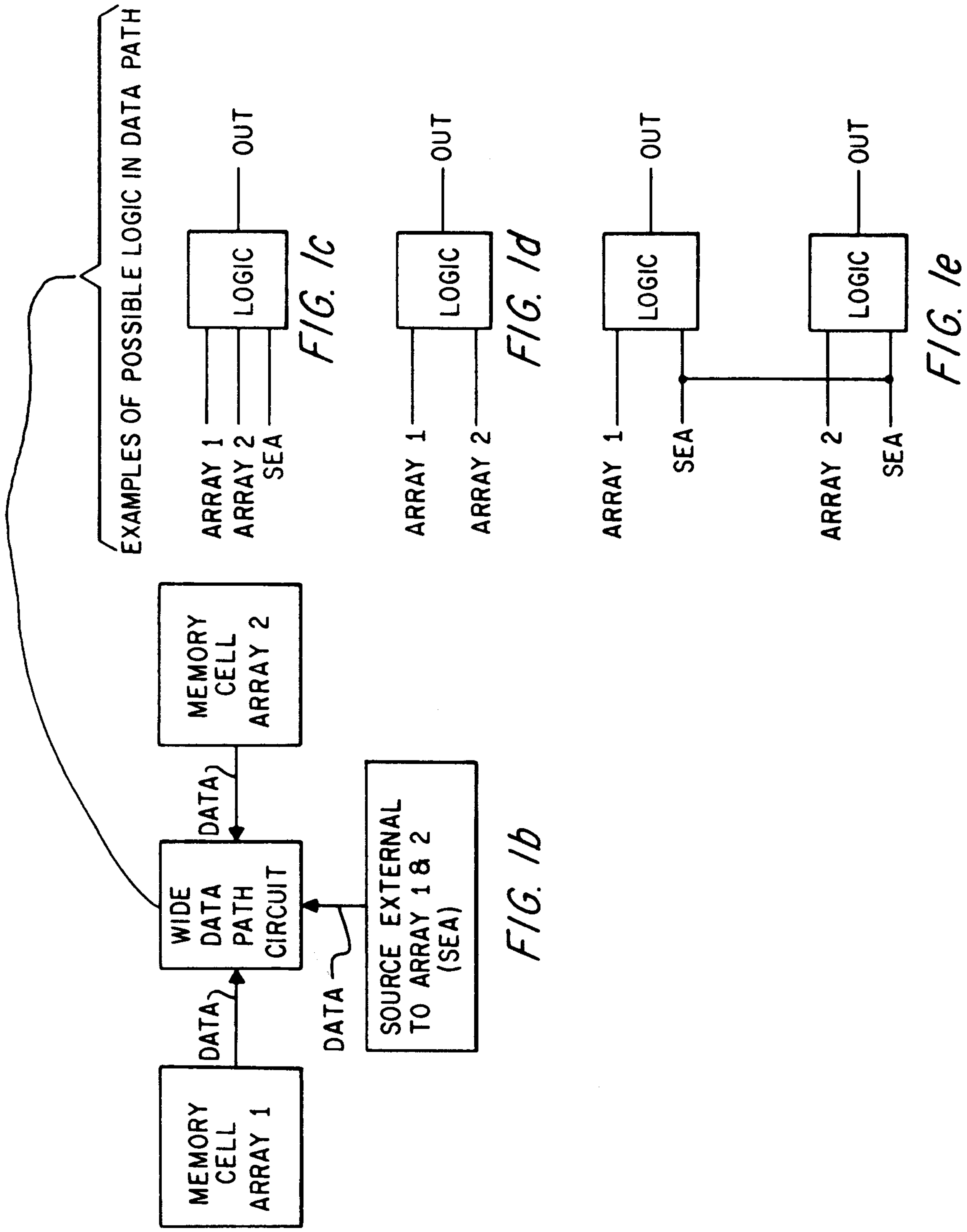


FIG. 1b

FIG. 1c

FIG. 1d

FIG. 1e

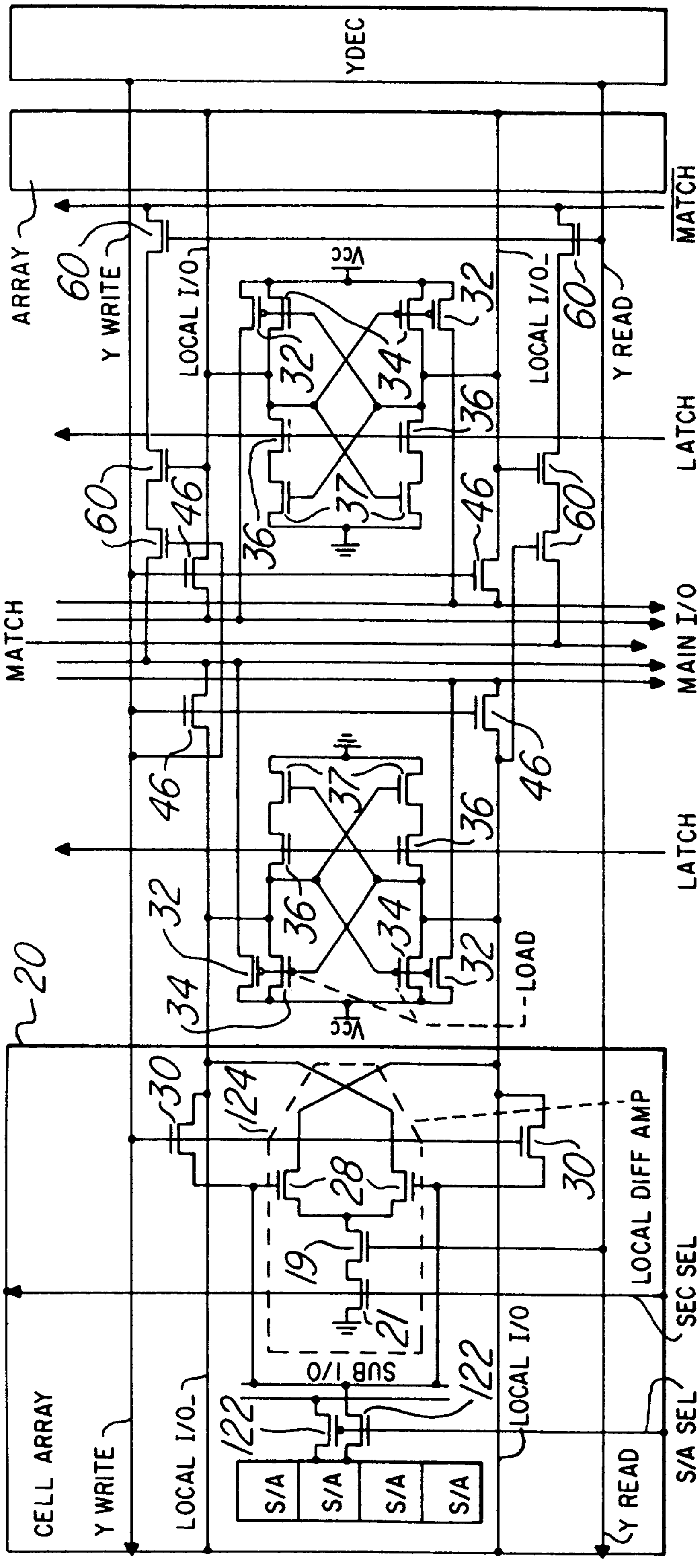
YDEC
ARRAY
MATCH
Y WRITE
LOCAL I/O
VCC
LOCAL I/O_
Y READ
LATCH
MAIN I/O
MATCH
LATCH
LOAD
CELL ARRAY
Y WRITE
LOCAL I/O_
S/A
S/A
S/A
S/A
SUB I/O
LOCAL I/O
LOCAL DIFF AMP
SEC SEL
S/A SEL
Y READ
20
30
124
28
19
21
122
32
34
36
37
46
60

FIG. 2

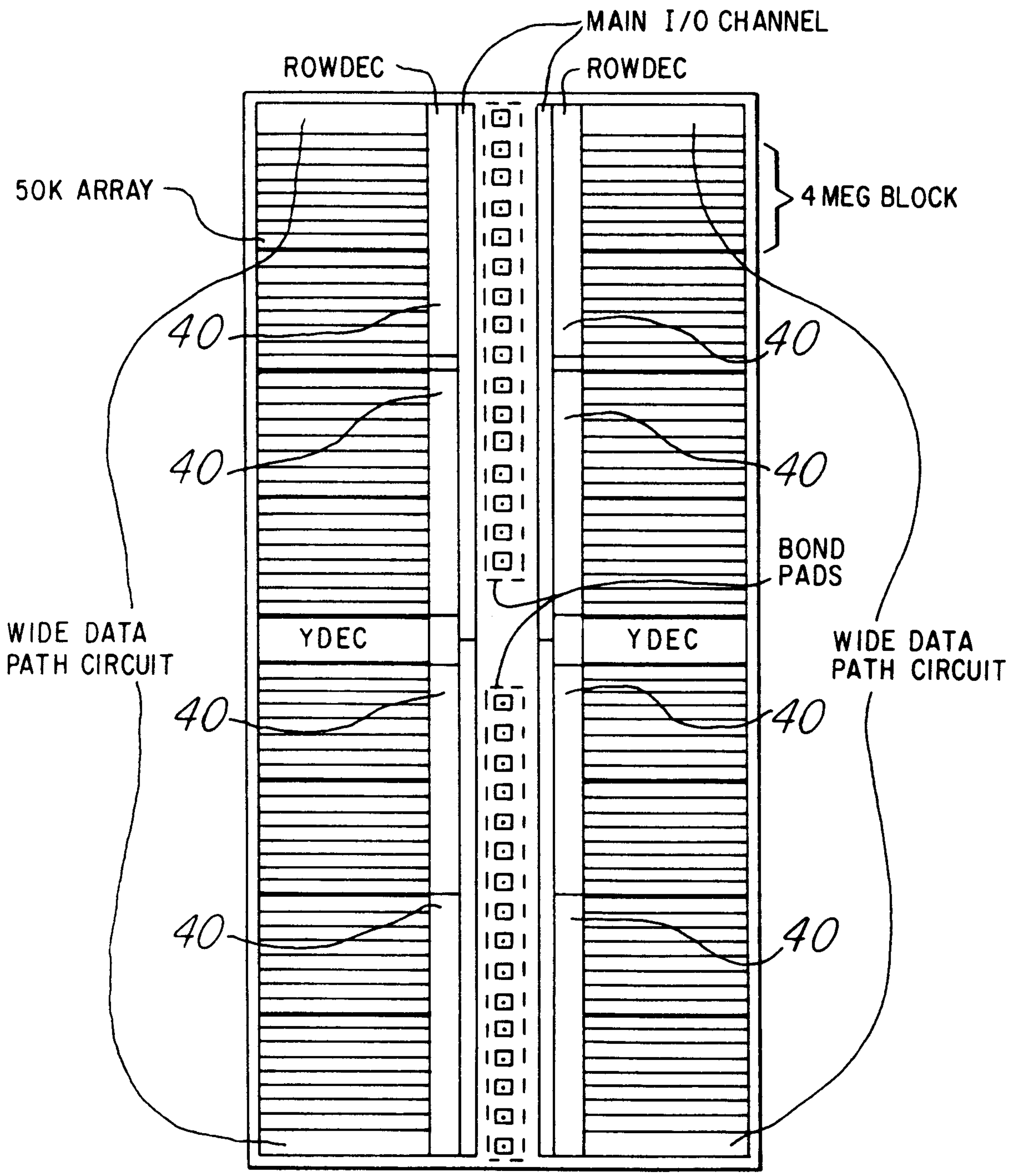
MAIN I/O CHANNEL
ROWDEC
ROWDEC
50K ARRAY
4 MEG BLOCK
40
40
40
40
BOND
PADS
WIDE DATA
PATH CIRCUIT
YDEC
YDEC
WIDE DATA
PATH CIRCUIT
40
40
40
40

FIG. 3a

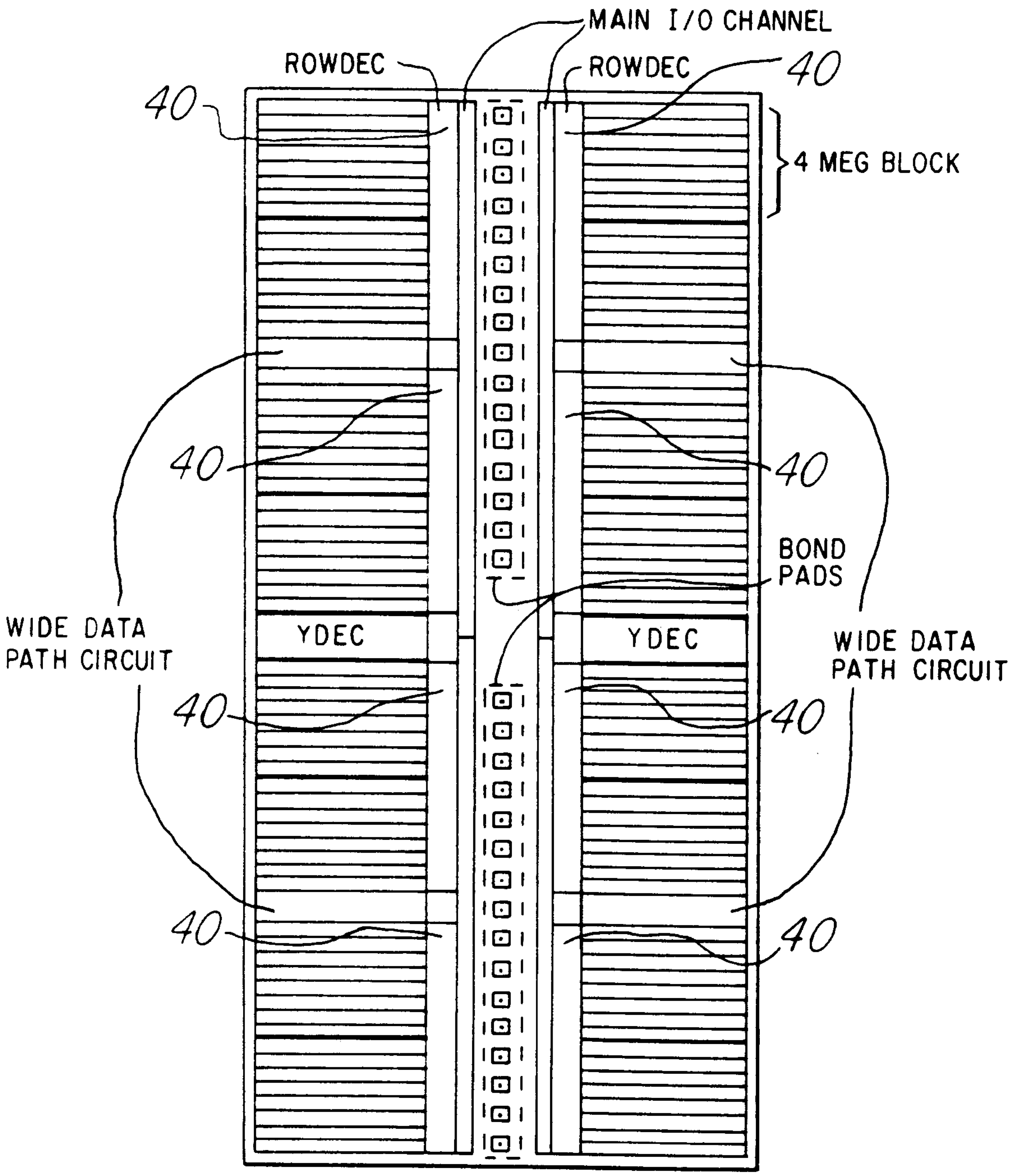
MAIN I/O CHANNEL
ROWDEC
ROWDEC
40
40
4 MEG BLOCK
40
40
BOND PADS
WIDE DATA PATH CIRCUIT
YDEC
YDEC
WIDE DATA PATH CIRCUIT
40
40
40
40

FIG. 3b

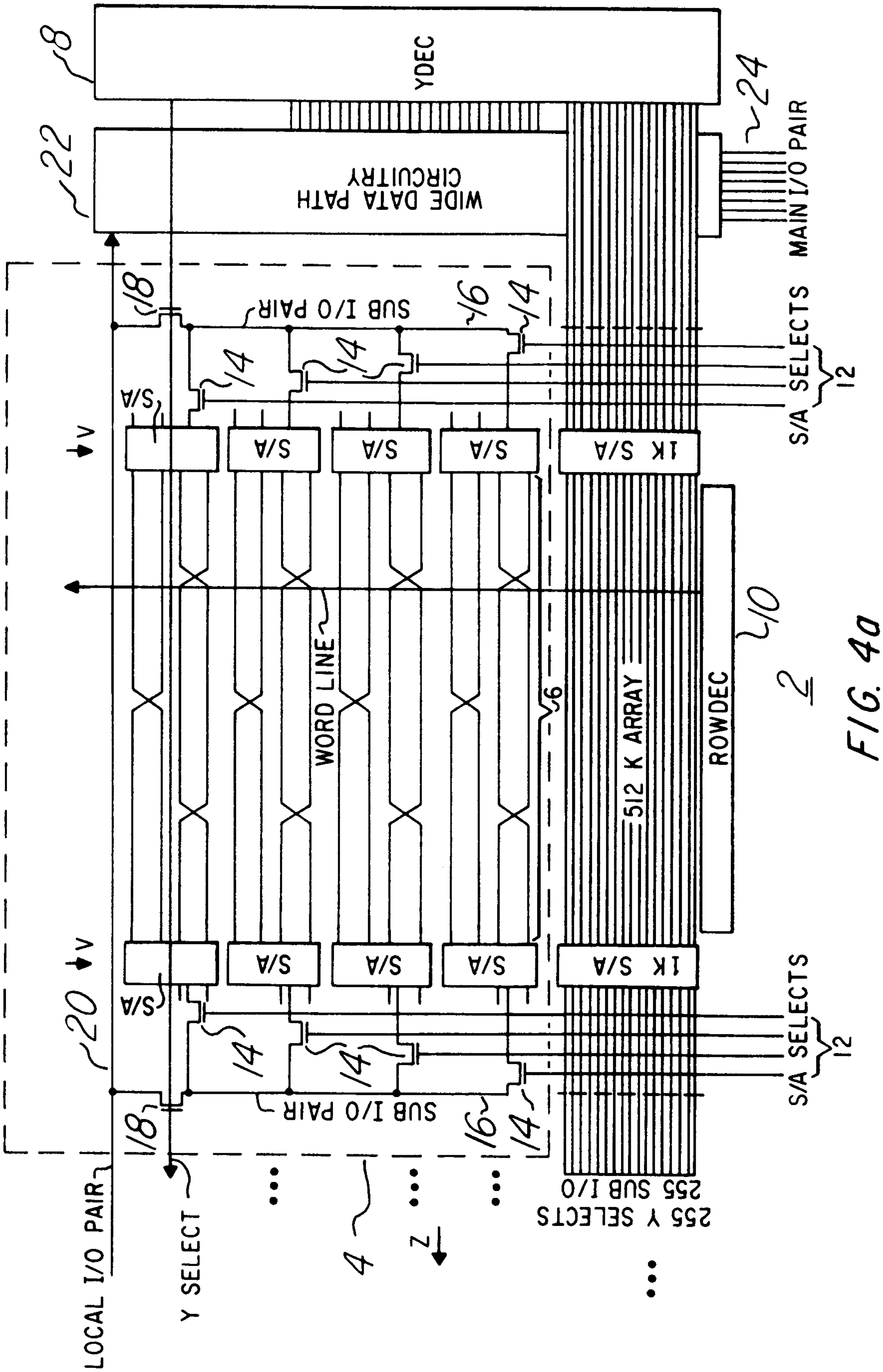
YDEC
WIDE DATA PATH CIRCUITRY
MAIN I/O PAIR
SUB I/O PAIR
S/A
1K S/A
S/A SELECTS
WORD LINE
512 K ARRAY
ROWDEC
LOCAL I/O PAIR
Y SELECT
255 Y SELECTS
255 SUB I/O
V
Z
2
4
6
8
10
12
14
16
18
20
22
24

FIG. 4a

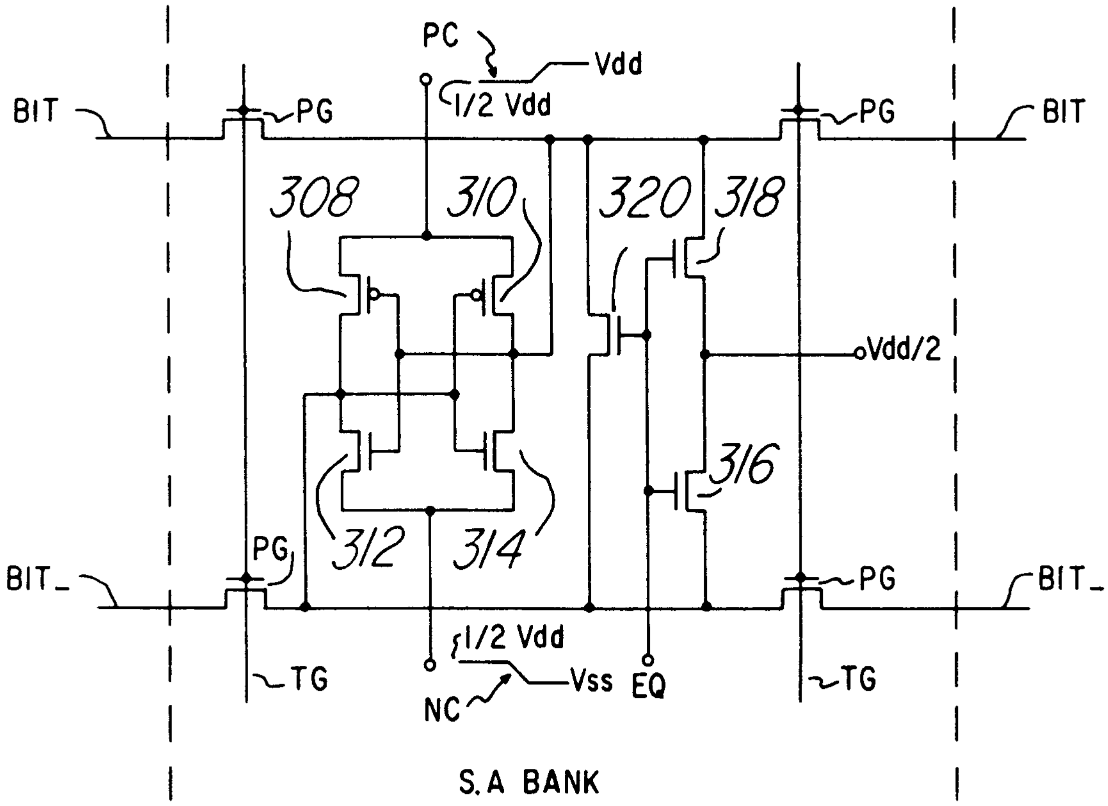
PC
Vdd
1/2 Vdd
BIT
PG
BIT
PG
308
310
320
318
Vdd/2
316
312
314
PG
PG
BIT_
BIT_
1/2 Vdd
Vss
EQ
TG
TG
NC
S.A BANK

FIG. 4b

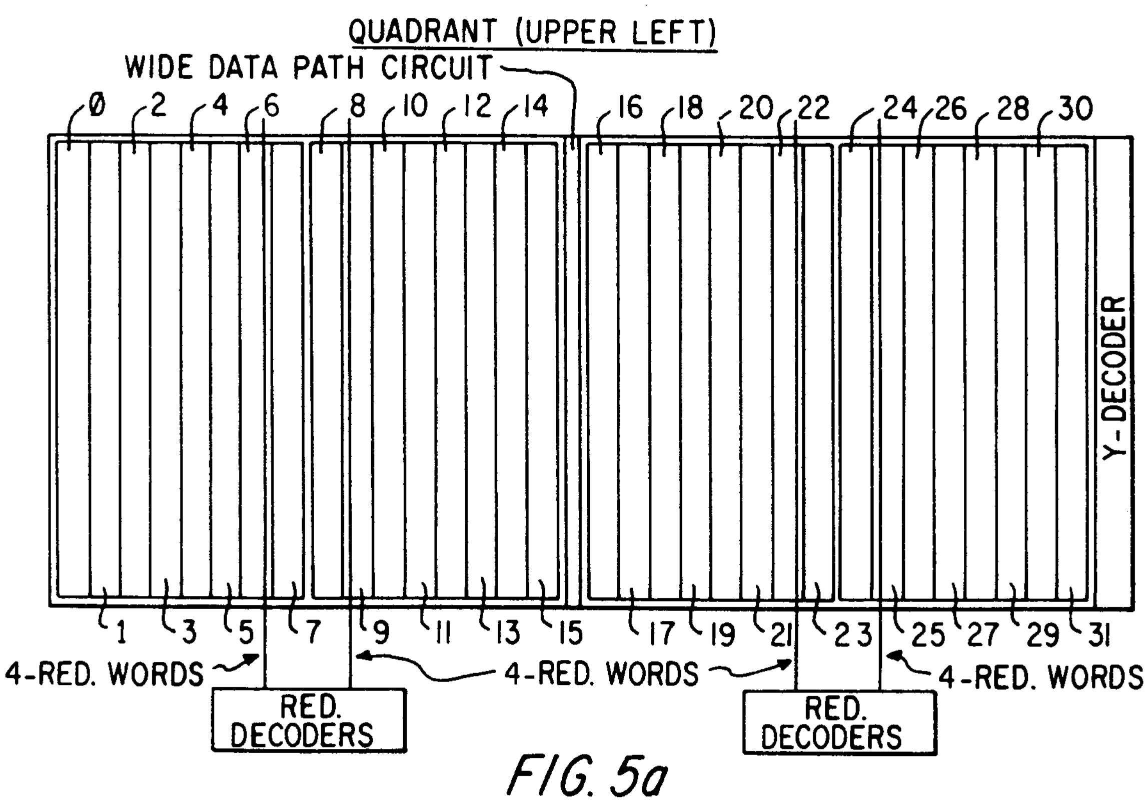
QUADRANT (UPPER LEFT)
WIDE DATA PATH CIRCUIT
Ø 2 4 6 8 10 12 14 16 18 20 22 24 26 28 30
Y-DECODER
1 3 5 7 9 11 13 15 17 19 21 23 25 27 29 31
4-RED. WORDS
4-RED. WORDS
4-RED. WORDS
RED. DECODERS
RED. DECODERS

FIG. 5a

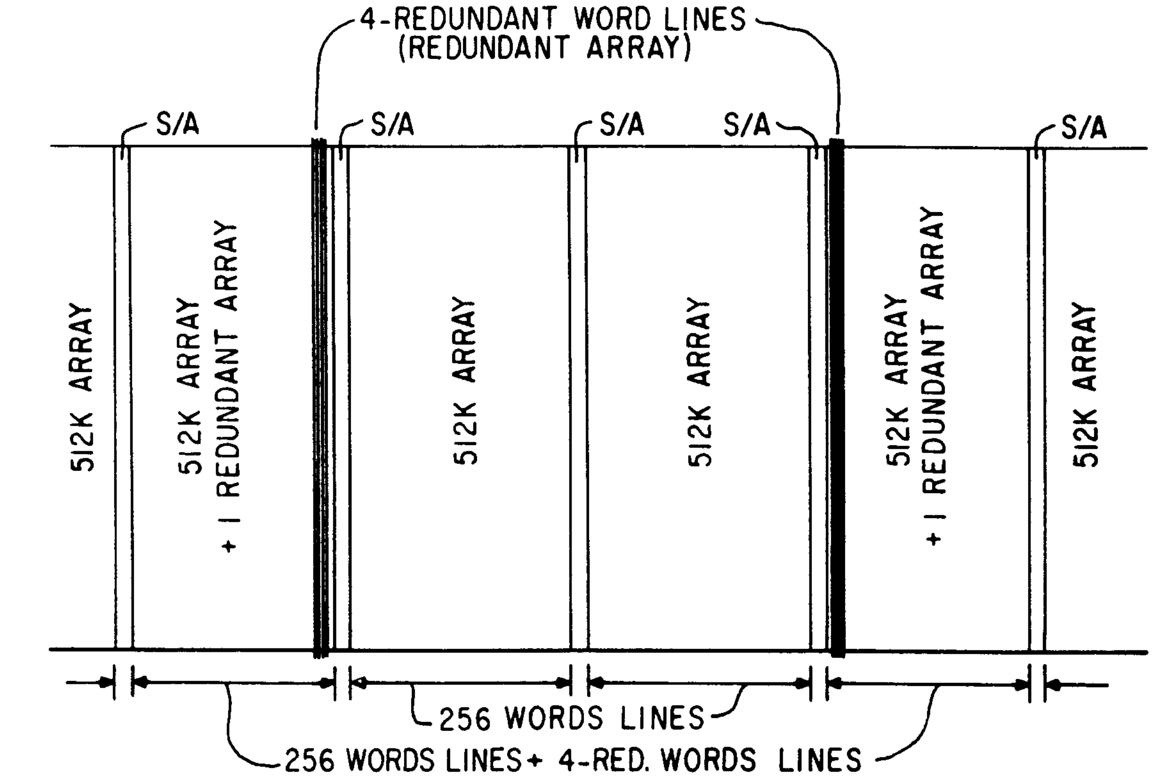
4-REDUNDANT WORD LINES
(REDUNDANT ARRAY)
S/A
S/A
S/A
S/A
S/A
512K ARRAY
512K ARRAY
+ 1 REDUNDANT ARRAY
512K ARRAY
512K ARRAY
512K ARRAY
+ 1 REDUNDANT ARRAY
512K ARRAY
256 WORDS LINES
256 WORDS LINES+ 4-RED. WORDS LINES

FIG. 5b

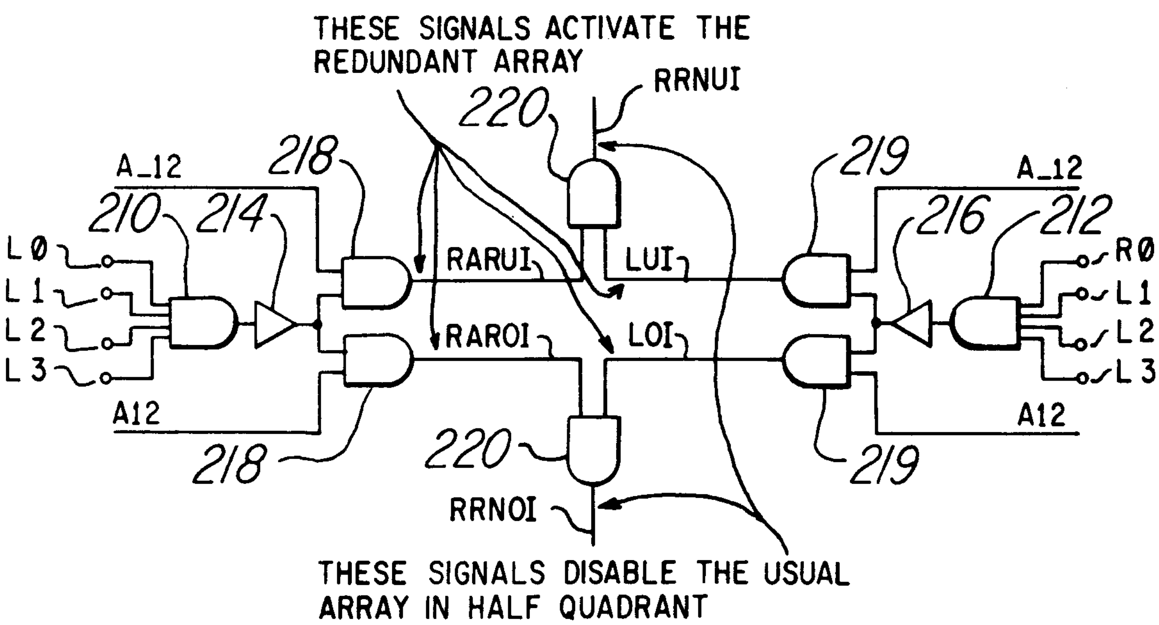
THESE SIGNALS ACTIVATE THE
REDUNDANT ARRAY
RRNUI
220
A_12
218
219
A_12
210
214
216
212
L Ø
L 1
L 2
L 3
RARUI
LUI
RØ
L1
L2
L3
RAROI
LOI
A12
A12
218
220
219
RRNOI
THESE SIGNALS DISABLE THE USUAL
ARRAY IN HALF QUADRANT

FIG. 6

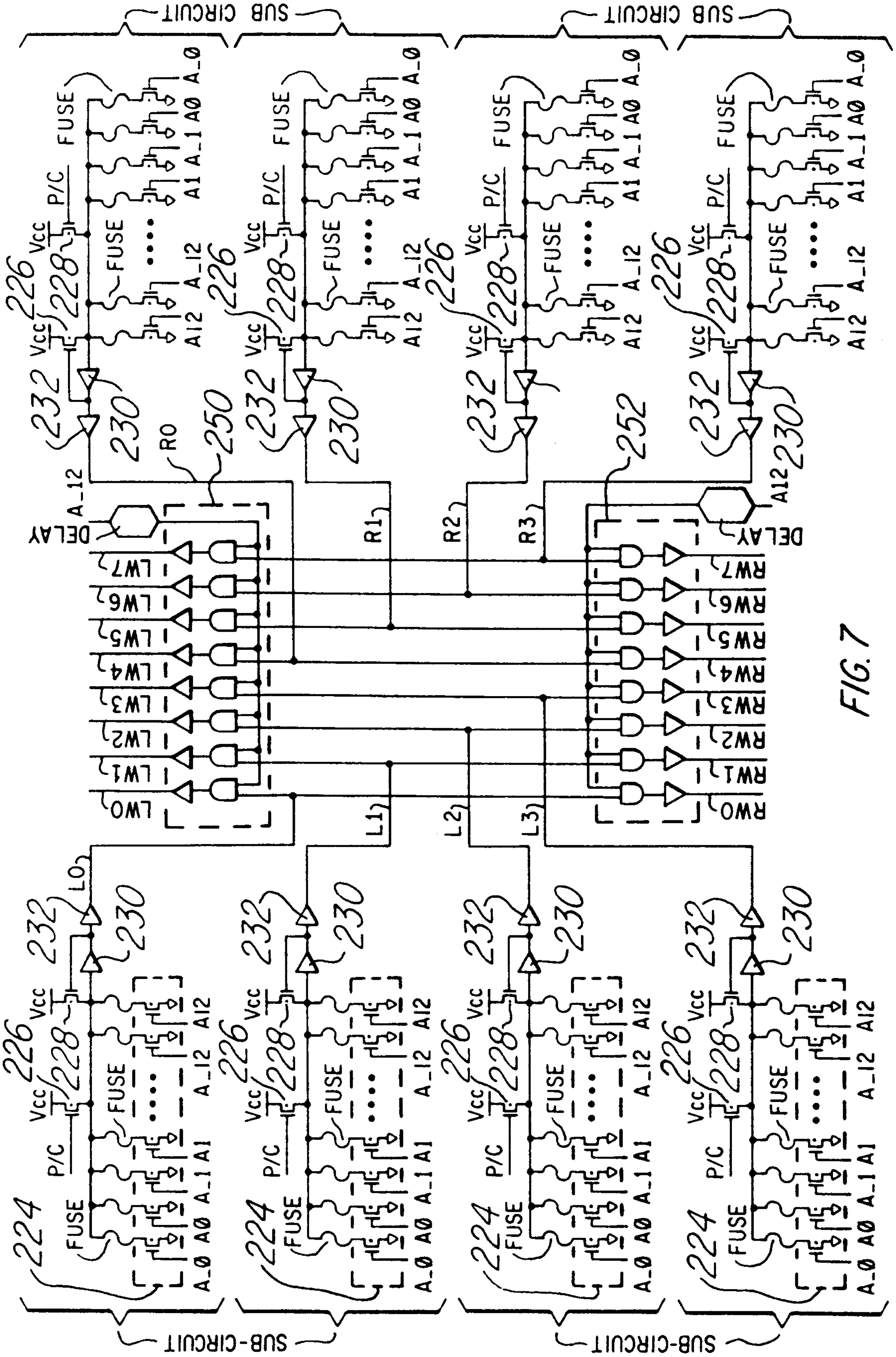
SUB CIRCUIT
SUB CIRCUIT
FUSE
P/C
Vcc
226
228
232
230
A12 A_12 A1 A_1 A0 A_0
DELAY
R0
R1
R2
R3
250
252
LW0 LW1 LW2 LW3 LW4 LW5 LW6 LW7
RW0 RW1 RW2 RW3 RW4 RW5 RW6 RW7
L0
L1
L2
L3
224
SUB-CIRCUIT
SUB-CIRCUIT

FIG. 7

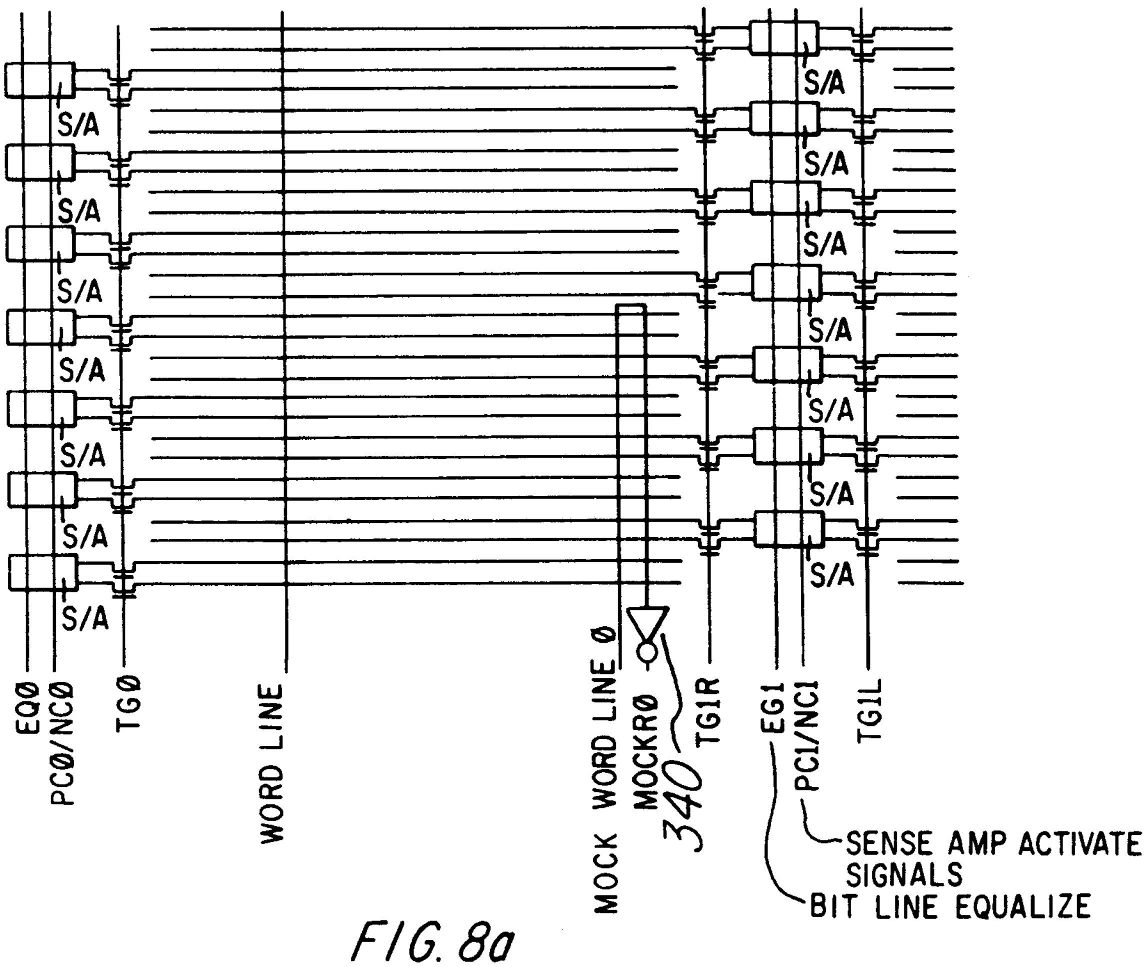
S/A
EQØ
PCØ/NCØ
TGØ
WORD LINE
MOCK WORD LINE Ø
MOCKRØ
340
TG1R
EG1
PC1/NC1
TG1L
SENSE AMP ACTIVATE SIGNALS
BIT LINE EQUALIZE

FIG. 8a

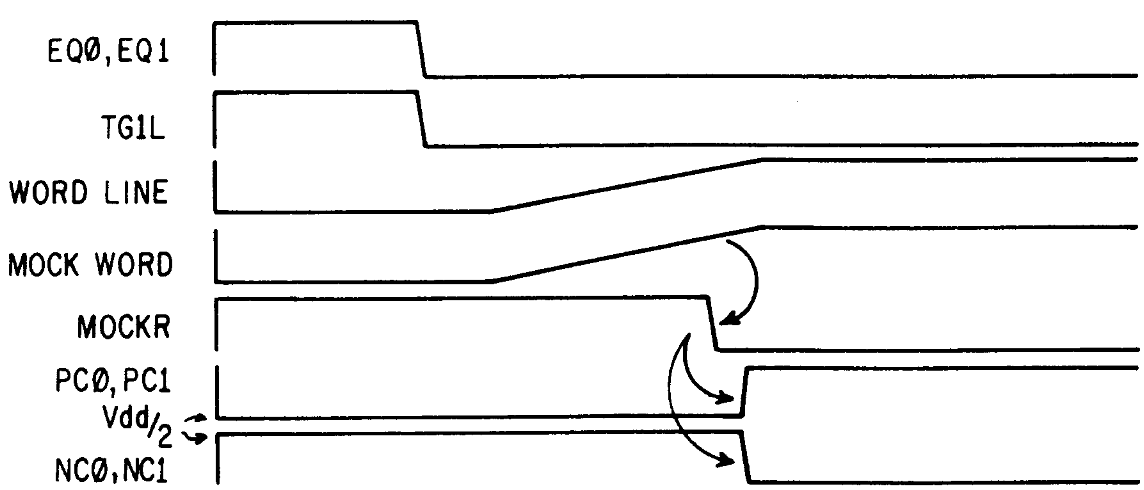
EQØ,EQ1
TG1L
WORD LINE
MOCK WORD
MOCKR
PCØ,PC1
Vdd/2
NCØ,NC1

FIG. 8b

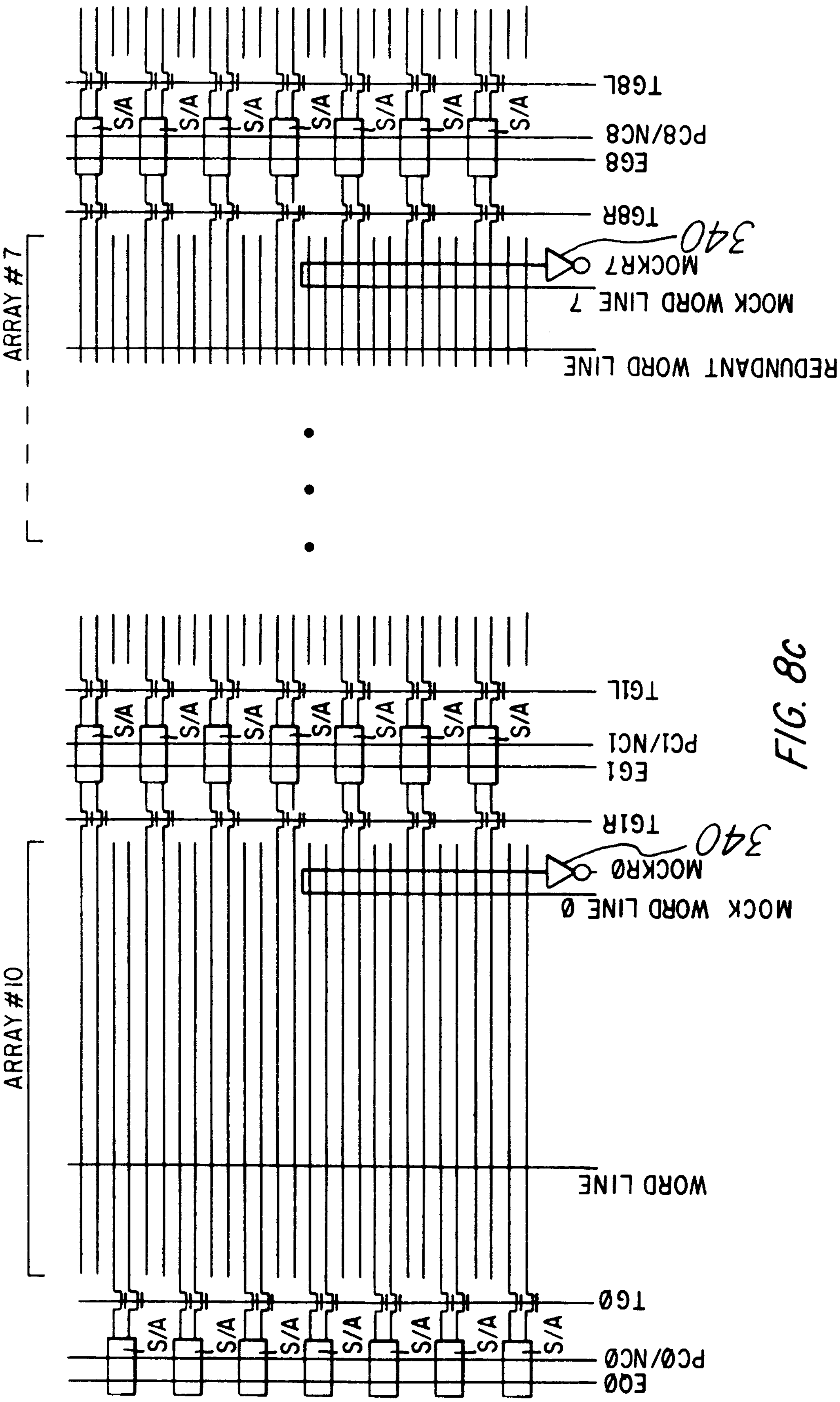
ARRAY #7
TG8L
S/A
PC8/NC8
EG8
TG8R
340
MOCKR7
MOCK WORD LINE 7
REDUNDANT WORD LINE
ARRAY #10
TG1L
PC1/NC1
EG1
TG1R
340
MOCKR0
MOCK WORD LINE 0
WORD LINE
TG0
PC0/NC0
EQ0

FIG. 8c

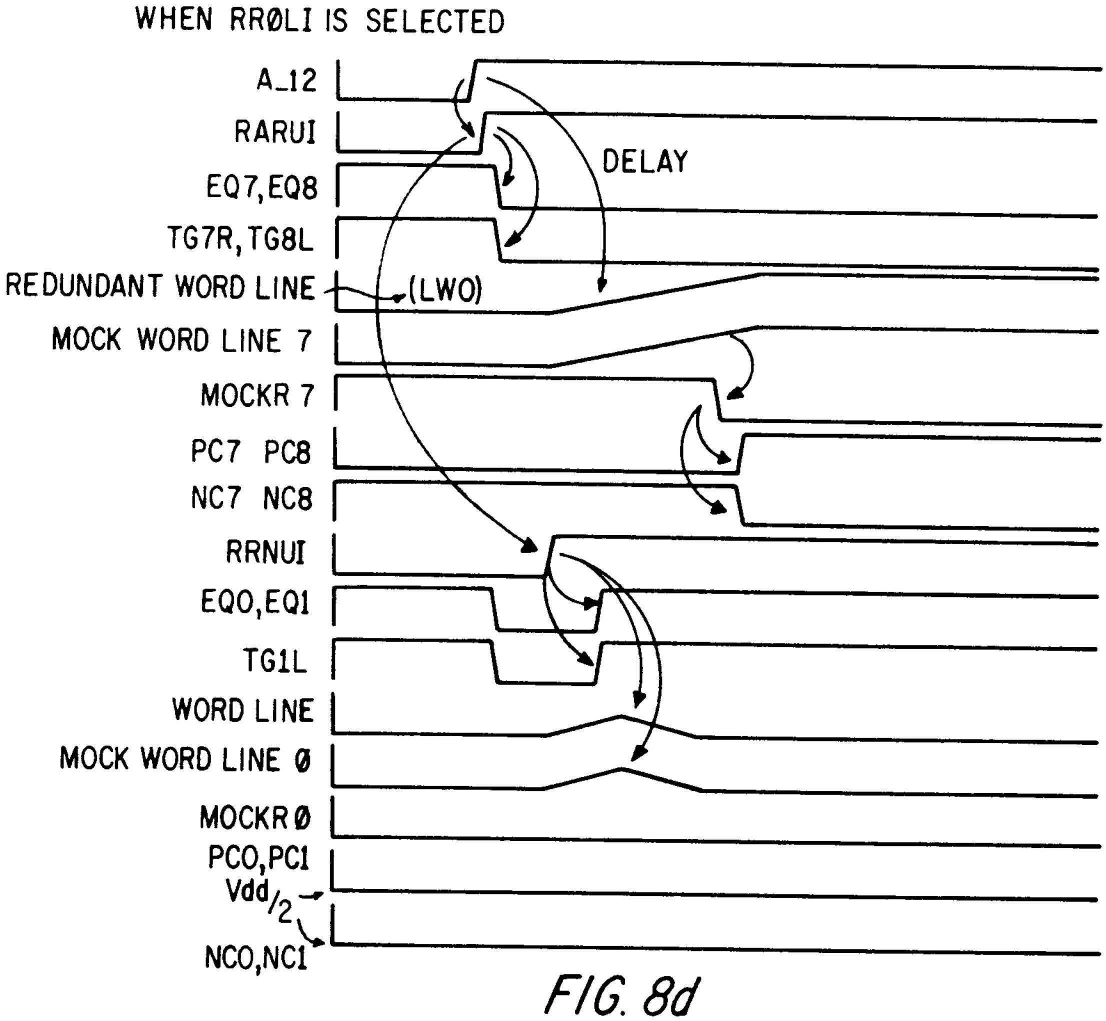
WHEN RRØLI IS SELECTED
A_12
RARUI
DELAY
EQ7,EQ8
TG7R,TG8L
REDUNDANT WORD LINE
(LWO)
MOCK WORD LINE 7
MOCKR 7
PC7 PC8
NC7 NC8
RRNUI
EQ0,EQ1
TG1L
WORD LINE
MOCK WORD LINE Ø
MOCKR Ø
PC0,PC1
Vdd/2
NC0,NC1

FIG. 8d

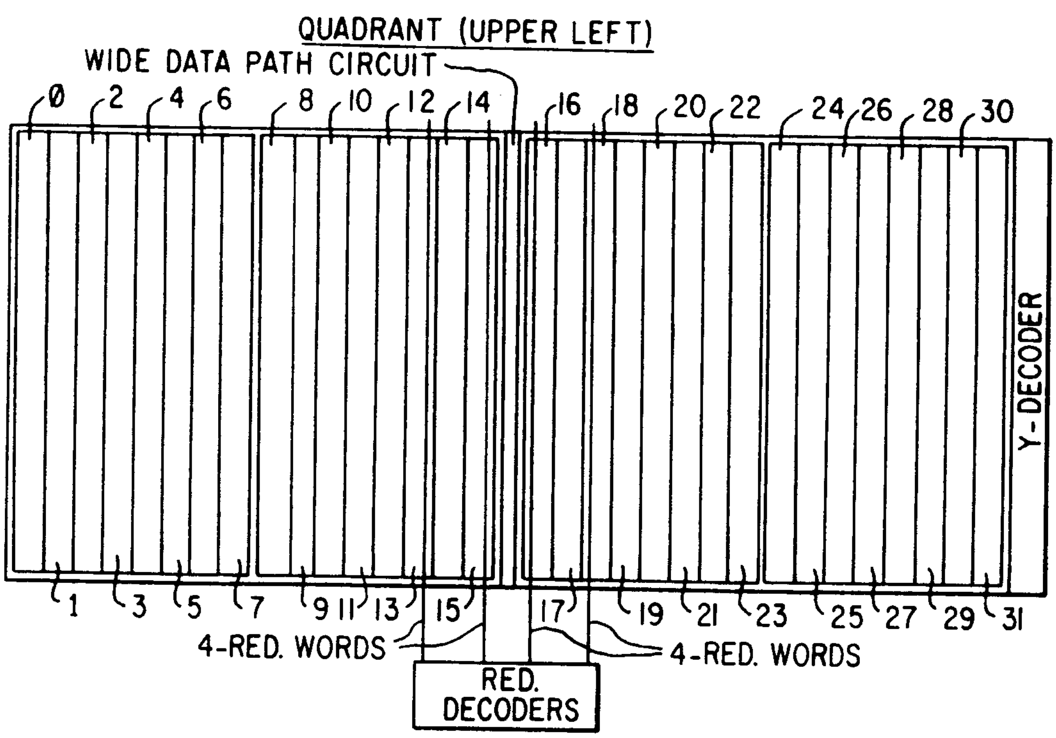
QUADRANT (UPPER LEFT)
WIDE DATA PATH CIRCUIT
Ø 2 4 6 8 10 12 14 16 18 20 22 24 26 28 30
1 3 5 7 9 11 13 15 17 19 21 23 25 27 29 31
4-RED. WORDS
4-RED. WORDS
RED. DECODERS
Y-DECODER

FIG. 9

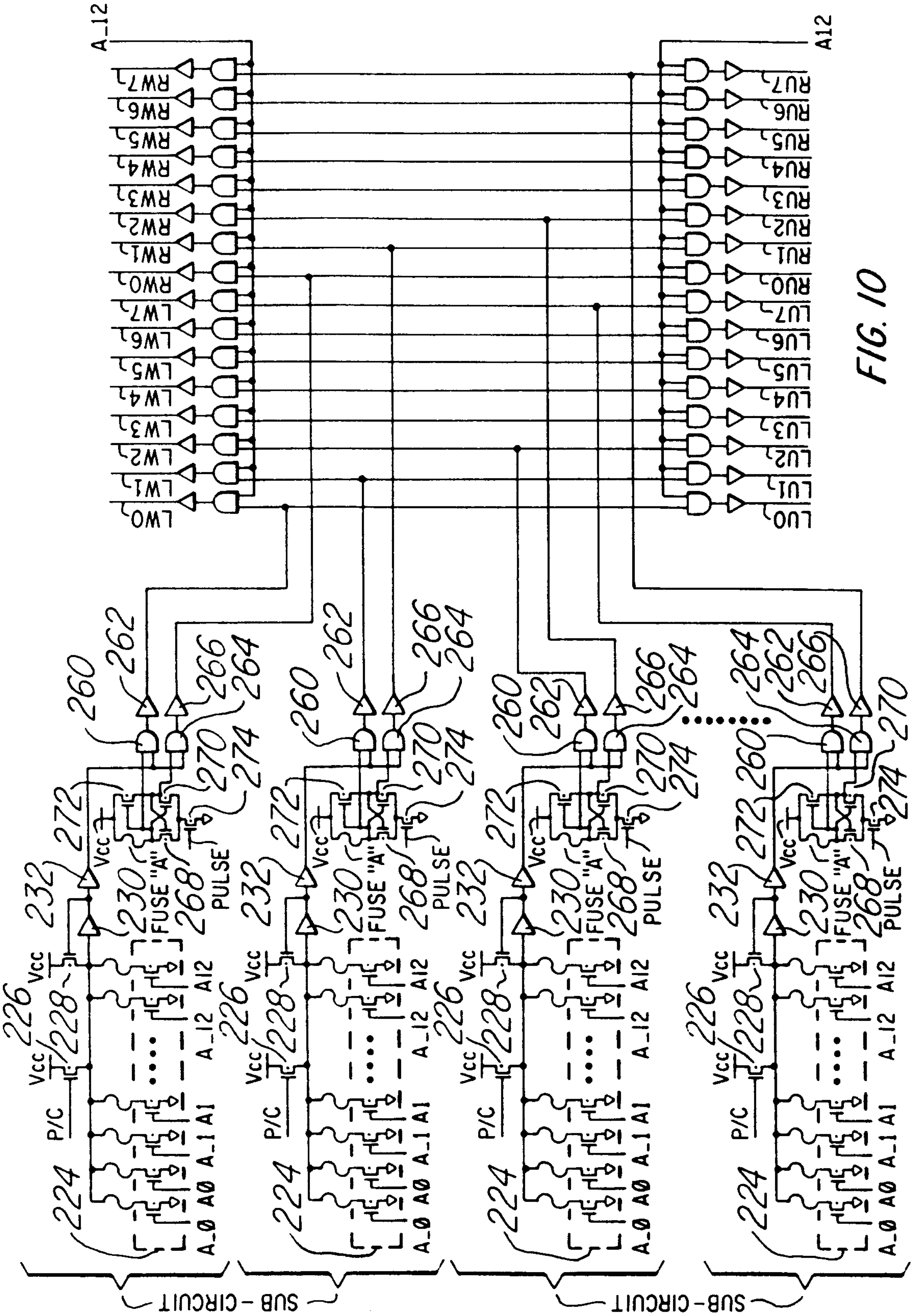
A_12
A12
RW7
RW6
RW5
RW4
RW3
RW2
RW1
RW0
LW7
LW6
LW5
LW4
LW3
LW2
LW1
LW0
RU7
RU6
RU5
RU4
RU3
RU2
RU1
RU0
LU7
LU6
LU5
LU4
LU3
LU2
LU1
LU0
260
262
264
266
270
272
274
232
230
268
226
228
224
Vcc
FUSE "A"
PULSE
P/C
A_Ø A0 A_1 A1
A_12 A12
SUB - CIRCUIT
SUB - CIRCUIT

FIG. 10

European Patent Office

# EUROPEAN SEARCH REPORT

Application Number

EP 92101917.0

| Category | DOCUMENTS CONSIDERED TO BE RELEVANT<br>Citation of document with indication, where appropriate, of relevant passages | Relevant to claim | CLASSIFICATION OF THE APPLICATION (Int. Cl.5) |
|---|---|---|---|
| A | EP - A - 0 146 357<br>(FUJITSU)<br>* Claims 1,2,3,4,5; fig. 3 *<br>-- | 1,2,3, 6,10 | G 11 C 29/00<br>G 06 F 11/20 |
| A | EP - A - 0 031 386<br>(FUJITSU)<br>* Page 10, lines 18-37; page 11, lines 1-12; claims 1,2; fig. 1 *<br>-- | 1,2,3, 10 | |
| A | US - A - 4 630 241<br>(KOBAYASHI et al.)<br>* Claims 1,3; fig. 4 *<br>-- | 1,2,3, 10 | |
| A | EP - A - 0 300 467<br>(NEC)<br>* Claims 1,4; fig. 2 *<br>-- | 1,2,3, 6,10 | |
| A | US - A - 4 441 170<br>(FOLMSBEE et al.)<br>* Claims 1,8 *<br>-- | 1,2,10 | TECHNICAL FIELDS SEARCHED (Int. Cl.5) |
| A | US - A - 4 376 300<br>(TSANG)<br>* Claims 7,11; fig. 1 *<br>---- | 1,2,3 | G 11 C<br>G 06 F |

The present search report has been drawn up for all claims

| Place of search | Date of completion of the search | Examiner |
|---|---|---|
| VIENNA | 13-05-1992 | MEHLMAUER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)